(19) Europäisches Patentamt
European Patent Office
Office européen des brevets

(11) **EP 2 977 773 B1**

(12) **FASCICULE DE BREVET EUROPEEN**

(45) Date de publication et mention de la délivrance du brevet:
**09.03.2022 Bulletin 2022/10**

(21) Numéro de dépôt: **15177954.3**

(22) Date de dépôt: **22.07.2015**

(51) Classification Internationale des Brevets (IPC):
***G01R 22/06*** *(2006.01)*

(52) Classification Coopérative des Brevets (CPC):
**G01R 22/066**

(54) **CAPTEUR À EFFET HALL VIRTUEL**

SENSOR MIT VIRTUELLEM HALL-EFFEKT

VIRTUAL HALL-EFFECT SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.07.2014 FR 1457151**

(43) Date de publication de la demande:
**27.01.2016 Bulletin 2016/04**

(73) Titulaire: **SAGEMCOM ENERGY & TELECOM SAS 92500 Rueil-Malmaison (FR)**

(72) Inventeurs:
• **TEBOULLE, Henri**
  **92500 RUEIL MALMAISON (FR)**
• **BOURGEOIS, Daniel**
  **92500 RUEIL MALMAISON (FR)**

(74) Mandataire: **Cabinet Le Guen Maillet**
  **3, impasse de la Vigie**
  **CS 71840**
  **35418 Saint-Malo Cedex (FR)**

(56) Documents cités:
**WO-A1-2014/106663    US-A1- 2004 021 568
US-A1- 2011 270 553**

**Description**

La présente invention concerne une détection de présence d'une source magnétique par une pluralité de capteurs à effet Hall.

Il est connu que des sources magnétiques, telles que des aimants permanents ou des électro-aimants, peuvent perturber des comportements de dispositifs. Par exemple, il est connu que des aimants peuvent fausser des mesures effectuées par un dispositif de métrologie, tel qu'un compteur électrique. Ce principe a été largement utilisé dans des cas de fraude à la consommation électrique : en effet, un individu malintentionné peut placer volontairement un aimant sur un compteur électrique pour fausser des mesures effectuées par ledit compteur électrique de sorte à ce que les mesures effectuées reflètent une consommation électrique bien inférieure à ce qui a été réellement consommé. Cette technique est aussi utilisée par des individus malintentionnés vis-à-vis de la nouvelle génération de compteurs électriques, appelés compteurs électriques intelligents (« smart meters » en anglais). En effet, selon un rapport publié en avril 2012 du journaliste et expert en sécurité américain Brian Krebs, la quasi-omniprésence des compteurs électriques intelligents n'est égalée que par la fréquence avec laquelle lesdits compteurs électriques intelligents sont piratés. Brian Krebs cite un rapport datant de 2010 du FBI (« Federal Bureau of Investigations » en anglais) dans lequel il est indiqué qu'il est possible de fausser des mesures de consommation électrique effectuées par un compteur électrique en plaçant un aimant très puissant sur ledit compteur électrique. Certains clients malintentionnés utilisent cette technique pour fausser les mesures pendant la nuit afin de laisser tourner des appareils de climatisation pour avoir une nuit bien fraîche jusqu'au lendemain. Les aimants sont ensuite retirés durant la journée lorsque les clients sont au travail.

Ce type de fraude est d'autant plus difficile à détecter dans le cas de compteurs électriques intelligents, du fait qu'un attrait des compteurs électriques intelligents est de pouvoir collecter les mesures de consommation électrique à distance sans qu'un agent ait besoin de se déplacer sur site. Il est alors souhaitable de pouvoir détecter la présence d'un tel aimant accolé à un compteur électrique intelligent et de pouvoir transmettre une alarme correspondante vers un équipement central de surveillance.

Pour détecter la présence de tels aimants, il est connu d'utiliser des détecteurs de champ magnétique, tels des interrupteurs Reed ou des capteurs à effet Hall. Un interrupteur Reed est un interrupteur magnétique comportant deux contacts en ferronickel, souvent protégés par une couche d'or et de zinc. Les contacts sont élastiques, magnétisés et placés dans une bulle de verre contenant typiquement du diazote. En présence d'un champ magnétique, les contacts sont attirés l'un par l'autre, se rapprochent et se touchent, permettant ainsi un passage de courant. Lorsque le champ magnétique cesse, les contacts s'écartent l'un de l'autre du fait de leur caractère élastique, ce qui interdit le passage de courant. Une présence de champ magnétique peut ainsi être détectée grâce à ce passage de courant. Dans le cas d'un capteur à effet Hall, un bobinage permet de générer un courant en présence d'un champ magnétique permettant ainsi de détecter une présence de champ magnétique.

WO2014/106663 A1, US2011/270553 et US2004/021568 montrent des méthodes et équipements de surveillance connues pour détecter les champs magnétiques à proximité des compteurs.

Cependant, l'utilisation de capteurs à effet Hall pose des problèmes de fiabilité de détection, et en particulier, selon l'orientation du champ magnétique, la présence d'une source magnétique indésirable peut ne pas être détectée, et ce, même en présence d'une pluralité de capteurs à effet Hall. En effet, des contraintes d'encombrement peuvent ne pas permettre de disposer des capteurs à effet Hall partout où il serait souhaitable de détecter la présence d'une telle source magnétique indésirable.

Il est souhaitable de pallier ces différents inconvénients de l'état de la technique.

D'une manière générale, il est souhaitable de fournir une solution qui permette d'étendre la capacité de détection de présence de source magnétique aux abords d'un dispositif à surveiller par une pluralité de capteurs à effet Hall, que cette source magnétique soit indésirable ou pas selon le contexte d'utilisation dudit dispositif.

Il est notamment souhaitable de fournir une solution qui soit simple à mettre en œuvre et à faible coût.

La présente invention concerne un procédé de surveillance d'un dispositif comportant une pluralité de capteurs à effet Hall, chaque capteur à effet Hall étant adapté pour détecter la présence d'une source magnétique génératrice d'un champ magnétique d'intensité supérieure à un premier seuil prédéfini $T_{src}$, lorsque ledit capteur à effet Hall mesure une intensité de champ magnétique supérieure en valeur absolue à un second seuil prédéfini respectif $S_i$. Ledit procédé est tel qu'il comporte les étapes suivantes : obtenir des mesures de champ magnétique effectuées respectivement par lesdits capteurs à effet Hall ; et détecter, lorsqu'une valeur $H$ de combinaison linéaire desdites mesures obtenues en valeur absolue est supérieure à un troisième seuil prédéfini $S_{tot}$, la présence d'une source magnétique génératrice d'un champ magnétique d'intensité supérieure audit premier seuil prédéfini $T_{src}$, alors que le champ magnétique mesuré par chaque capteur à effet Hall est d'intensité inférieure ou égale en valeur absolue audit second seuil prédéfini respectif $S_i$. Ainsi, la combinaison linéaire des mesures effectuées par lesdits capteurs à effet Hall permet de créer un capteur à effet Hall virtuel qui permet de détecter une présence de source magnétique, bien qu'aucun des capteurs à effet Hall pris indépendamment ne permette de détecter la présence de ladite source magnétique.

Selon un mode de réalisation particulier, le procédé comporte une étape consistant à générer une alarme, lorsque la valeur H de combinaison linéaire desdites mesures obtenues est supérieure au troisième seuil prédéfini $S_{tot}$.

Selon un mode de réalisation particulier, le procédé comporte l'étape suivante, pour chaque capteur à effet Hall : comparer la mesure obtenue avec le second seuil prédéfini respectif $S_i$ ; et ledit procédé comporte en outre l'étape suivante : générer l'alarme, lorsqu'au moins une parmi lesdites mesures obtenues est supérieure audit second seuil prédéfini respectif $S_i$.

Selon un mode de réalisation particulier, ledit troisième seuil prédéfini $S_{tot}$ est défini selon la formule suivante :

$$S_{tot} = L . \sqrt{\sum_{i=0}^{N-1} S_i^2}$$

où i est un index représentatif d'un capteur à effet Hall parmi la pluralité de capteurs à effet Hall, et où L est un coefficient égal à $1/\sqrt{N}$ permettant d'assurer que, lorsque tous les seconds seuils prédéfinis $S_i$ sont identiques, le troisième seuil prédéfini $S_{tot}$ soit aussi égal à chaque second seuil prédéfini $S_i$, $N$ représentant la quantité de capteurs à effet Hall.

Selon un mode de réalisation particulier, la valeur H de combinaison linéaire desdites mesures obtenues est déterminée de la façon suivante :

$$H = \sum_{i=0}^{N-1} a_i . H_i$$

où $H_i$ représente la mesure effectuée par le capteur à effet Hall représenté par l'index i et $a_i$ représente un coefficient prédéfini de pondération de la mesure obtenue du capteur à effet Hall identifié par l'index i, chaque coefficient de pondération $a_i$ étant prédéfini selon la formule suivante :

$$a_i = K . \frac{S_{tot}}{S_i}$$

où $K$ est un coefficient d'ajustement.

La présente invention concerne également un équipement de surveillance d'un dispositif comportant une pluralité de capteurs à effet Hall, chaque capteur à effet Hall étant adapté pour détecter la présence d'une source magnétique génératrice d'un champ magnétique d'intensité supérieure à un premier seuil prédéfini $T_{src}$, lorsque ledit capteur à effet Hall mesure une intensité de champ magnétique supérieure en valeur absolue à un second seuil prédéfini respectif $S_i$. Ledit équipement est tel qu'il comporte : des moyens pour obtenir des mesures de champ magnétique effectuées respectivement par lesdits capteurs à effet Hall ; et des moyens pour détecter, lorsqu'une valeur H de combinaison linéaire desdites mesures obtenues en valeur absolue est supérieure à un troisième seuil prédéfini $S_{tot}$, la présence d'une source magnétique génératrice d'un champ magnétique d'intensité supérieure audit premier seuil prédéfini $T_{src}$, alors que le champ magnétique mesuré par chaque capteur à effet Hall est d'intensité inférieure ou égale en valeur absolue audit second seuil prédéfini respectif $S_i$.

La présente invention concerne également un compteur électrique adapté pour mesurer une consommation électrique d'une installation électrique alimentée par un réseau d'alimentation électrique, et comportant l'équipement de surveillance précédemment mentionné, ledit compteur électrique étant le dispositif comportant lesdits capteurs à effet Hall.

Selon un mode de réalisation particulier, le compteur électrique comporte : une interface de communication par courants porteurs en ligne adaptée pour communiquer via ledit réseau d'alimentation électrique ; des moyens pour générer une alarme, lorsque la valeur H de combinaison linéaire desdites mesures obtenues est supérieure au troisième seuil prédéfini $S_{tot}$ ; et des moyens pour transmettre un message représentatif de ladite alarme via ladite interface de communication par courants porteurs en ligne.

Les caractéristiques de la présente invention mentionnées ci-dessus, ainsi que d'autres, apparaîtront plus clairement à la lecture de la description suivante d'un exemple de réalisation, ladite description étant faite en relation avec les dessins joints, parmi lesquels :

-	la Fig. 1 illustre schématiquement un dispositif comportant une pluralité de capteurs à effet Hall et pour lequel la présente invention peut être mise en œuvre ;
-	la Fig. 2 illustre schématiquement une architecture matérielle d'un équipement adapté pour surveiller ledit dispositif vis-à-vis d'une présence de source magnétique aux abords dudit dispositif ;
-	la Fig. 3 illustre schématiquement un algorithme, mis en œuvre par ledit équipement, pour détecter la présence de source magnétique indésirable aux abords dudit dispositif, selon un premier mode de réalisation de la présente invention ; et
-	la Fig. 4 illustre schématiquement un algorithme, mis en œuvre par ledit équipement, pour détecter la présence de source magnétique indésirable aux abords dudit dispositif, selon un second mode de réalisation de la présente invention.

La description détaillée ci-après s'attache à décrire différents modes de réalisation de la présente invention dans un contexte de compteur électrique muni d'une pluralité de capteurs à effet Hall, et plus particulièrement dans un contexte de compteur électrique intelligent. Les principes de la présente invention s'appliquent cependant dans un contexte plus large de métrologie sensible aux champs magnétiques, ou plus généralement, de dispositif dont le fonctionnement peut être perturbé par une présence aux abords dudit dispositif d'une source magnétique, cette présence de source magnétique devant par conséquent être détectée. Les principes de la présente invention s'appliquent aussi dans un contexte général dans lequel un dispositif à surveiller comporte une pluralité de capteurs à effet Hall et pour lequel une présence de source magnétique génératrice d'un champ magnétique d'intensité supérieure à un seuil prédéfini $T_{src}$, que la présence d'une telle source magnétique soit indésirable ou pas.

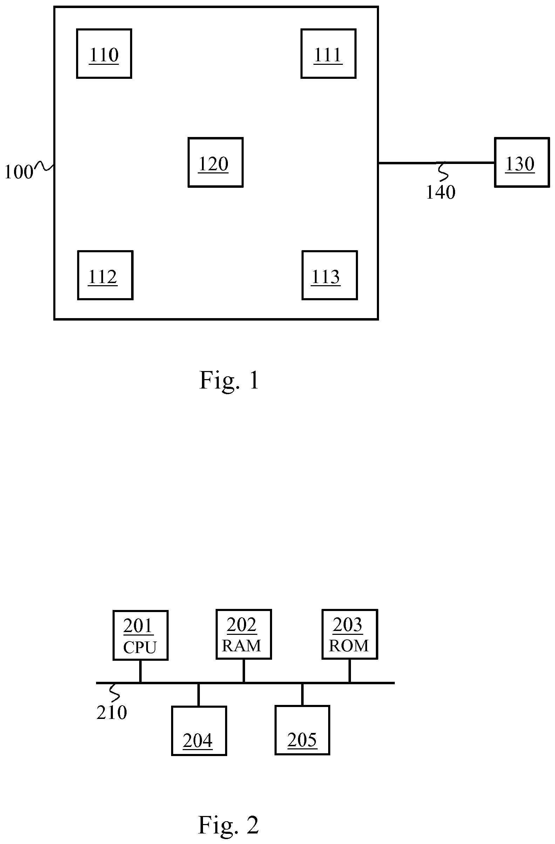

La Fig. 1 illustre schématiquement un dispositif 100 comportant une pluralité de capteurs à effet Hall 110, 111, 112, 113 et pour lequel la présente invention peut être mise en œuvre.

Les capteurs à effet Hall sont destinés à permettre à un équipement de surveillance 130 de surveiller le dispositif 100 vis-à-vis d'une présence de source magnétique génératrice d'un champ magnétique d'intensité supérieure au seuil prédéfini $T_{src}$ aux abords dudit dispositif 100.

Chaque capteur à effet Hall est adapté pour effectuer des mesures de champ magnétique, et est adapté pour détecter la présence d'une source magnétique génératrice d'un champ magnétique d'intensité supérieure au seuil prédéfini $T_{src}$, lorsque ledit capteur à effet Hall mesure une intensité de champ magnétique supérieure en valeur absolue à un seuil prédéfini respectif $S_i$ (i étant un index représentant un capteur à effet Hall parmi ladite pluralité, un seuil prédéfini respectif $S_i$ est associé à chaque capteur à effet Hall). Le principe est que si ledit capteur à effet Hall mesure une intensité de champ magnétique supérieure en valeur absolue au seuil prédéfini $S_i$ associé audit capteur à effet Hall, on considère qu'une source magnétique indésirable est aux abords du dispositif 100. Cette source magnétique peut être génératrice d'un champ magnétique d'intensité légèrement supérieure au seuil prédéfini $T_{src}$ et être géographiquement très proche dudit dispositif 100, voire positionnée contre une paroi externe dudit dispositif 100, et être considérée comme étant de manière indésirable aux abords du dispositif 100. Cette source magnétique peut être aussi génératrice d'un champ magnétique d'intensité nettement supérieure au seuil prédéfini $T_{src}$ et être géographiquement plus éloignée dudit dispositif 100, et être considérée comme étant de manière indésirable aux abords du dispositif 100. Cela dépend de l'intensité de champ magnétique telle que mesurée, c'est-à-dire perçue, en valeur absolue par ledit capteur à effet Hall.

On considère que la présence d'une source magnétique génératrice d'un champ magnétique inférieure ou égale au seuil prédéfini $T_{src}$ aux abords du dispositif 100 n'est pas à détecter par les capteurs à effet Hall 110, 111, 112, 113, car de telles sources magnétiques sont considérées comme non perturbantes pour ledit dispositif 100.

Chaque seuil $S_i$ est typiquement défini par expérimentation. En effet, les capteurs à effet Hall sont typiquement entourés d'une protection mécanique, ce qui limite les possibilités d'approcher une source magnétique desdits capteurs à effet Hall. Chaque seuil $S_i$ est alors déterminé par expérimentation pour prendre en compte cette limitation physique liée à l'agencement des capteurs à effet Hall respectifs 110, 111, 112, 113 vis-à-vis du dispositif 100. Les expérimentations peuvent utiliser des sources magnétiques, telles que des aimants, de forces d'attractivité différentes, de formes différentes et de matières différentes, et qui vont donc entraîner des mesures de champ magnétique différentes par les capteurs à effet Hall respectifs 110, 111, 112, 113.

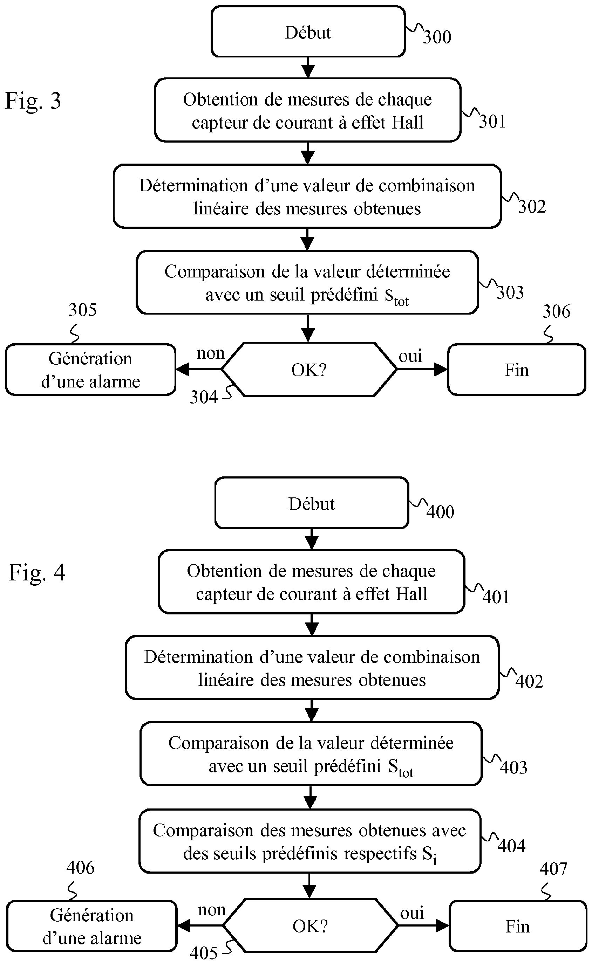

Ces seuils prédéfinis $S_i$ peuvent être utilisés pour générer des alarmes de détection, individuellement par les capteurs à effet Hall respectifs 110, 111, 112, 113, d'une présence de source magnétique génératrice de champ magnétique d'intensité supérieure audit premier seuil prédéfini $T_{src}$, tel que décrit ci-après en relation avec la Fig. 4.

En fonctionnement de l'agencement des capteurs à effet Hall 110, 111, 112, 113, il se peut que la présence d'une source magnétique génératrice d'un champ magnétique d'intensité supérieure au seuil prédéfini $T_{src}$ aux abords du dispositif 100 ne soit pas détectée individuellement par les capteurs à effet Hall 110, 111, 112, 113, car lesdits capteurs à effet Hall 110, 111, 112, 113 peuvent être en situation de ne percevoir qu'une intensité inférieure ou égale au seuil prédéfini $T_{src}$ du champ magnétique généré par ladite source magnétique. En effet, comme déjà mentionné, l'encombrement du dispositif 100 peut empêcher de disposer des capteurs à effet Hall 110, 111, 112, 113 partout où il serait souhaitable de détecter l'existence d'un champ magnétique indésirable pouvant perturber le fonctionnement du dispositif 100. Le rôle de l'équipement de surveillance 130 est de pallier cet inconvénient, de la manière décrite ci-après en relation avec la Fig. 3 ou la Fig. 4.

Pour ce faire, le dispositif 100 est adapté pour fournir, via un lien de communication 140, à l'équipement de surveillance 130 des mesures effectuées par les capteurs à effet Hall 110, 111, 112, 113.

Sur la Fig. 1, l'équipement de surveillance 130 est représenté comme étant distinct du dispositif 100 et comme étant connecté au dispositif 100 via le lien de communication 140. Dans un autre mode de réalisation, l'équipement de surveillance 130 est intégré dans le dispositif 100 ; en d'autres termes, dans ce cas, le dispositif 100 implémente le comportement et les fonctionnalités de l'équipement de surveillance 130.

Dans un mode de réalisation particulier, le dispositif 100 est un compteur électrique adapté pour mesurer une consommation électrique d'une installation électrique alimentée par un réseau d'alimentation électrique.

Dans un mode de réalisation particulier, le dispositif 100 est un compteur électrique intelligent adapté pour mesurer une consommation électrique d'une installation électrique alimentée par un réseau d'alimentation électrique, et disposant d'une interface de communication par courants porteurs en ligne (« powerline communication » en anglais) adaptée pour communiquer via ledit réseau d'alimentation électrique, notamment avec un équipement central de surveillance. L'équipement de surveillance 130 peut alors être intégré dans ledit compteur électrique intelligent et être adapté pour transmettre des messages d'alarmes à l'équipement central de surveillance via ladite interface de communication par courants porteurs en ligne. Selon un autre mode de réalisation, l'équipement de surveillance 130 est localisé au niveau de l'équipement central de surveillance et le compteur électrique intelligent est adapté pour transmettre, à l'équipement de surveillance 130 via ladite interface de communication par courants porteurs en ligne, des mesures effectuées par lesdits capteurs à effet Hall.

La Fig. 2 illustre schématiquement un exemple d'architecture matérielle de l'équipement de surveillance 130. Cette architecture matérielle peut donc se trouver incorporée au dispositif 100, lorsque ledit dispositif 100 implémente le comportement et les fonctionnalités de l'équipement de surveillance 130.

Selon l'exemple d'architecture matérielle représenté à la Fig. 2, l'équipement de surveillance 130 comprend alors, reliés par un bus de communication 210 : un processeur ou CPU (« Central Processing Unit » en anglais) 201 ; une mémoire vive RAM (« Random Access Memory » en anglais) 202 ; une mémoire morte ROM (« Read Only Memory » en anglais) 203 ; une unité de stockage ou un lecteur de support de stockage, tel qu'un lecteur de cartes SD (« Secure Digital » en anglais) 204 ; au moins une interface de communication 205 permettant à l'équipement de surveillance 130 de recevoir les mesures effectuées par les capteurs à effet Hall 110, 111, 112, 113, et permettant éventuellement de communiquer, directement ou indirectement, avec l'équipement central de surveillance pour envoyer des messages d'alarme.

Le processeur 201 est capable d'exécuter des instructions chargées dans la RAM 202 à partir de la ROM 203, d'une mémoire externe (non représentée), d'un support de stockage (tel qu'une carte SD), ou d'un réseau de communication. Lorsque l'équipement de surveillance 130 est mis sous tension, le processeur 201 est capable de lire de la RAM 202 des instructions et de les exécuter. Ces instructions forment un programme d'ordinateur causant la mise en œuvre, par le processeur 201, de tout ou partie des algorithmes et étapes décrits ci-après en relation avec les Figs. 3 et 4.

Tout ou partie des algorithmes et étapes décrits ci-après en relation avec les Figs. 3 et 4 peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais).

La Fig. 3 illustre schématiquement un algorithme, mis en œuvre par l'équipement de surveillance 130, pour détecter une présence de source magnétique indésirable aux abords dudit dispositif, selon un premier mode de réalisation de la présente invention. L'algorithme de la Fig. 3 débute dans une étape 300.

Dans une étape 301, l'équipement de surveillance 130 obtient des mesures effectuées par les capteurs à effet Hall 110, 111, 112, 113. Les mesures peuvent être signées, l'équipement de surveillance 130 en conservant alors la valeur absolue. Les mesures peuvent être des mesures instantanées effectuées par les capteurs à effet Hall 110, 111, 112, 113 ou peuvent être des intégrations, sur une durée prédéfinie D, de mesures instantanées effectuées par les capteurs à effet Hall 110, 111, 112, 113.

Dans une étape 302, l'équipement de surveillance 130 détermine une valeur $H$ de combinaison linéaire des mesures obtenues à l'étape 301. En d'autres termes, la valeur $H$ de combinaison linéaire desdites mesures obtenues est déterminée selon la formule suivante :

$$H = \sum_{i=0}^{N-1} a_i . H_i$$

où N représente la quantité de capteurs à effet Hall dont les mesures sont considérées, $H_i$ représente la mesure effectuée par le capteur à effet Hall représenté par l'index i et $a_i$ représente un coefficient prédéfini de pondération de chaque mesure. Chaque coefficient de pondération $a_i$ peut être défini de manière expérimentale, notamment en fonction de l'agencement géométrique relatif des capteurs à effet Hall 110, 111, 112, 113.

Dans une étape 303, l'équipement de surveillance 130 compare la valeur H de combinaison linéaire déterminée avec un seuil prédéfini $S_{tot}$. La valeur du seuil $S_{tot}$ peut être prédéfinie en fonction du seuil prédéfini $T_{src}$ et de l'agencement géométrique relatif des capteurs à effet Hall 110, 111, 112, 113.

Dans un mode de réalisation particulier, le seuil prédéfini $S_{tot}$ est défini par une moyenne quadratique des seuils prédéfinis $S_i$ pondérée par un coefficient L, selon la formule suivante :

$$S_{tot} = L . \sqrt{\sum_{i=0}^{N-1} S_i^2}$$

où L est un coefficient égal à $1/\sqrt{N}$ permettant d'assurer que, lorsque tous les seuils prédéfinis $S_i$ sont identiques, le seuil prédéfini $S_{tot}$ soit aussi égal à chaque seuil prédéfini $S_i$.

Selon un mode de réalisation particulier, chaque coefficient de pondération $a_i$ peut être défini selon la formule suivante :

$$a_i = K . \frac{S_{tot}}{S_i}$$

où K représente un coefficient d'ajustement, par exemple égal à 0,75.

Dans une étape 304, l'équipement de surveillance 130 détermine si une présence de source magnétique génératrice de champ magnétique d'intensité supérieure audit seuil prédéfini $T_{src}$ est détectée en fonction de la valeur H de combinaison linéaire desdites mesures obtenues à l'étape 301. La présence d'une telle source magnétique est détectée lorsque la valeur H de combinaison linéaire desdites mesures obtenues à l'étape 301 est supérieure au seuil prédéfini $S_{tot}$. Si la présence d'une telle source magnétique est détectée, une étape 305 est effectuée ; sinon, il est mis fin à l'algorithme de la Fig. 3 dans une étape 306.

Dans l'étape 305, l'équipement de surveillance 130 génère une alarme représentative d'une détection de présence d'une source magnétique génératrice d'un champ magnétique d'intensité supérieure audit seuil prédéfini $T_{src}$, c'est-à-dire d'une source magnétique considérée comme pouvant perturber le fonctionnement du dispositif 100. Cette alarme peut être générée grâce à un voyant dédié, ou via un affichage sur un écran de l'équipement de surveillance 130, ou via un message transmis via un réseau de communication auquel l'équipement de surveillance 130 a accès. Plus particulièrement dans le cas d'un compteur électrique intelligent intégrant l'équipement de surveillance 130, l'alarme peut être générée grâce à un message transmis par courants porteurs en ligne via le réseau d'alimentation électrique alimentant l'installation électrique dont la consommation électrique est surveillée par ledit compteur électrique intelligent. Il est ensuite mis fin à l'algorithme de la Fig. 3.

L'algorithme de la Fig. 3 peut être exécuté sur demande, ou en continu, ou périodiquement.

La Fig. 4 illustre schématiquement un algorithme, mis en œuvre par l'équipement de surveillance 130, pour détecter une présence de source magnétique indésirable aux abords dudit dispositif, selon un second mode de réalisation de la présente invention. L'algorithme de la Fig. 4 débute dans une étape 400.

Dans une étape 401, l'équipement de surveillance 130 obtient des mesures effectuées par les capteurs à effet Hall 110, 111, 112, 113. L'étape 401 est identique à l'étape 301 de l'algorithme de la Fig. 3.

Dans une étape 402, l'équipement de surveillance 130 détermine la valeur H de combinaison linéaire des mesures obtenues à l'étape 401. L'étape 402 est identique à l'étape 302 de l'algorithme de la Fig. 3.

Dans une étape 403, l'équipement de surveillance 130 compare la valeur H de combinaison linéaire déterminée avec le seuil prédéfini $S_{tot}$. L'étape 403 est identique à l'étape 303 de l'algorithme de la Fig. 3.

Dans une étape 404, l'équipement de surveillance 130 compare, pour chaque capteur à effet Hall identifié par l'index i, la mesure $H_i$ avec le seuil prédéfini $S_i$ correspondant.

Dans une étape 405, l'équipement de surveillance 130 détermine si une présence de source magnétique génératrice de champ magnétique d'intensité supérieure audit seuil prédéfini $T_{src}$ est détectée par les capteurs à effet Hall 110, 111, 112, 113, que ce soit à titre individuel ou collectif. La présence d'une telle source magnétique est détectée à titre collectif lorsque la valeur H de combinaison linéaire desdites mesures obtenues à l'étape 401 est supérieure au seuil prédéfini $S_{tot}$. La présence d'une telle source magnétique est détectée à titre individuel par un capteur à effet Hall identifié par l'index i lorsque la mesure $H_i$ obtenue à l'étape 401 est supérieure au seuil prédéfini $S_i$ correspondant. Si la présence d'une telle source magnétique est détectée que ce soit à titre individuel ou collectif, une étape 406 est effectuée ; sinon, il est mis fin à l'algorithme de la Fig. 4 dans une étape 407.

Dans l'étape 406, l'équipement de surveillance 130 génère une alarme représentative d'une détection de présence d'une source magnétique génératrice d'un champ magnétique d'intensité supérieure audit seuil prédéfini $T_{src}$, c'est-à-dire d'une source magnétique considérée comme pouvant perturber le fonctionnement du dispositif 100. Cette alarme peut être générée grâce à un voyant dédié, ou via un affichage sur un écran de l'équipement de surveillance 130, ou via un message transmis via un réseau de communication auquel l'équipement de surveillance 130 a accès. Cette alarme peut distinguer le fait que ladite source magnétique ait été détectée par les capteurs à effet Hall 110, 111, 112, 113 à titre individuel ou à titre collectif. Plus particulièrement dans le cas d'un compteur électrique intelligent intégrant l'équipement de surveillance 130, l'alarme peut être générée grâce à un message transmis par courants porteurs en ligne via le réseau d'alimentation électrique alimentant l'installation électrique dont la consommation électrique est surveillée par ledit compteur électrique intelligent. Il est ensuite mis fin à l'algorithme de la Fig. 4.

L'algorithme de la Fig. 4 peut être exécuté sur demande, ou en continu, ou périodiquement.

Ainsi, au vu de tout ce qui précède, la présente invention permet de détecter la présence d'une source magnétique génératrice d'un champ magnétique d'intensité supérieure audit seuil prédéfini $T_{src}$, alors qu'aucun des capteurs à effet Hall pris indépendamment ne permet de détecter la présence de ladite source magnétique car la mesure effectuée par chaque capteur à effet Hall est inférieure ou égale au seuil prédéfini $S_i$ associé audit capteur à effet Hall. La combinaison linéaire des mesures desdits capteurs à effet Hall permet alors de créer un capteur à effet Hall virtuel.

## Revendications

1. Procédé de surveillance d'un dispositif (100) comportant une pluralité de capteurs à effet Hall (110, 111, 112, 113), chaque capteur à effet Hall étant adapté pour détecter la présence d'une source magnétique génératrice d'un champ magnétique d'intensité supérieure à un premier seuil prédéfini $T_{src}$ lorsque ce capteur à effet Hall mesure une intensité de champ magnétique supérieure en valeur absolue à un second seuil prédéfini respectif $S_i$, ledit procédé comportant l'étape suivante :

     - obtenir (301 ; 401) des mesures de champ magnétique effectuées respectivement par lesdits capteurs à effet Hall ; et ledit procédé étant **caractérisé en ce qu'**il comporte l'étape suivante :
     - détecter (304 ; 405), lorsqu'une valeur H de combinaison linéaire desdites mesures obtenues en valeur absolue est supérieure à un troisième seuil prédéfini $S_{tot}$, la présence d'une source magnétique génératrice d'un champ magnétique d'intensité supérieure audit premier seuil prédéfini $T_{src}$, alors que le champ magnétique mesuré par chaque capteur à effet Hall est d'intensité inférieure ou égale en valeur absolue audit second seuil prédéfini respectif $S_i$.

2. Procédé selon la revendication 1, **caractérisé en ce qu'**il comporte une étape consistant à générer (305 ; 406) une alarme, lorsque la valeur H de combinaison linéaire desdites mesures obtenues est supérieure au troisième seuil prédéfini $S_{tot}$.

3. Procédé selon la revendication 2, **caractérisé en ce qu'**il comporte l'étape suivante, pour chaque capteur à effet Hall :

     - comparer (404) la mesure obtenue avec le second seuil prédéfini respectif $S_i$, ; et **en ce que** ledit procédé comporte en outre l'étape suivante :
     - générer (406) l'alarme, lorsqu'au moins une parmi lesdites mesures obtenues est supérieure audit second seuil prédéfini respectif $S_i$.

4. Procédé selon l'une quelconque des revendications 1 à 3, **caractérisé en ce que** ledit troisième seuil prédéfini $S_{tot}$ est défini selon la formule suivante :

$$S_{tot} = L . \sqrt{\sum_{i=0}^{N-1} S_i^{\,2}}$$

où *i* est un index représentatif d'un capteur à effet Hall parmi la pluralité de capteurs à effet Hall, et où L est un coefficient égal à $1/\sqrt{N}$ permettant d'assurer que, lorsque tous les seconds seuils prédéfinis $S_i$ sont identiques, le troisième seuil prédéfini $S_{tot}$ soit aussi égal à chaque second seuil prédéfini $S_i$, N représentant la quantité de capteurs à effet Hall.

5. Procédé selon la revendication 4, **caractérisé en ce que** la valeur H de combinaison linéaire desdites mesures obtenues est déterminée de la façon suivante :

$$H = \sum_{i=0}^{N-1} a_i . H_i$$

où $H_i$ représente la mesure effectuée par le capteur à effet Hall représenté par l'index *i* et $a_i$ représente un coefficient prédéfini de pondération de la mesure obtenue du capteur à effet Hall identifié par l'index *i*, chaque coefficient de pondération $a_i$ étant prédéfini selon la formule suivante :

$$a_i = K . \frac{S_{tot}}{S_i}$$

où *K* est un coefficient d'ajustement.

6. Equipement de surveillance (130) d'un dispositif (100) comportant une pluralité de capteurs à effet Hall (110, 111, 112, 113), chaque capteur à effet Hall étant adapté pour détecter la présence d'une source magnétique génératrice d'un champ magnétique d'intensité supérieure à un premier seuil prédéfini $T_{src}$ lorsque ce capteur à effet Hall mesure une intensité de champ magnétique supérieure en valeur absolue à un second seuil prédéfini respectif $S_i$, ledit équipement comportant :

     - des moyens pour obtenir (301 ; 401) des mesures de champ magnétique effectuées respectivement par lesdits capteurs à effet Hall ; et ledit équipement étant **caractérisé en ce qu'**il comporte :
- des moyens pour détecter (304 ; 405), lorsqu'une valeur H de combinaison linéaire desdites mesures obtenues en valeur absolue est supérieure à un troisième seuil prédéfini $S_{tot}$, la présence d'une source magnétique génératrice d'un champ magnétique d'intensité supérieure audit premier seuil prédéfini $T_{src}$, alors que le champ magnétique mesuré par chaque capteur à effet Hall est d'intensité inférieure ou égale en valeur absolue audit second seuil prédéfini respectif $S_i$.

7. Compteur électrique adapté pour mesurer une consommation électrique d'une installation électrique alimentée par un réseau d'alimentation électrique, **caractérisé en ce qu'**il comporte l'équipement de surveillance selon la revendication 6, ledit compteur électrique étant le dispositif comportant lesdits capteurs à effet Hall.

8. Compteur électrique selon la revendication 7, **caractérisé en ce qu'**il comporte :

   - une interface de communication par courants porteurs en ligne adaptée pour communiquer via ledit réseau d'alimentation électrique ;
   - des moyens pour générer (305 ; 406) une alarme, lorsque la valeur H de combinaison linéaire desdites mesures obtenues est supérieure au troisième seuil prédéfini $S_{tot}$ ; et
   - des moyens pour transmettre un message représentatif de ladite alarme via ladite interface de communication par courants porteurs en ligne.

9. Programme d'ordinateur, **caractérisé en ce qu'**il comprend des instructions pour mettre en œuvre, par un équipement de surveillance selon la revendication 6, le procédé selon l'une quelconque des revendications 1 à 5, lorsque ledit programme est exécuté par un processeur dudit équipement de surveillance.

10. Moyens de stockage, **caractérisés en ce qu'**ils stockent un programme d'ordinateur comprenant des instructions pour mettre en œuvre, par un équipement de surveillance selon la revendication 6, le procédé selon l'une quelconque des revendications 1 à 5, lorsque ledit programme est exécuté par un processeur dudit équipement de surveillance.

**Patentansprüche**

1. Verfahren zur Überwachung einer Vorrichtung (100), die eine Vielzahl von Hall-Sensoren (110, 111, 112, 113) aufweist, wobei jeder Hall-Sensor geeignet ist, das Vorhandensein einer ein Magnetfeld einer höheren Stärke als eine vordefinierte erste Schwelle $T_{src}$ erzeugenden Magnetquelle zu erfassen, wenn dieser Hall-Sensor eine Magnetfeldstärke im Absolutwert höher als eine vordefinierte zweite Schwelle $S_i$ misst, wobei das Verfahren den folgenden Schritt aufweist:

   - Erhalt (301; 401) von Magnetfeldmessungen, die von den Hall-Sensoren ausgeführt werden;

und das Verfahren **dadurch gekennzeichnet ist, dass** es den folgenden Schritt aufweist:

   - wenn ein Wert H einer linearen Kombination der erhaltenen Messungen im Absolutwert höher ist als eine vordefinierte dritte Schwelle $S_{tot}$, Erfassen (304; 405) des Vorhandenseins einer Magnetquelle, die ein Magnetfeld einer Stärke höher als die vordefinierte erste Schwelle $T_{src}$ erzeugt, während das von jedem Hall-Sensor gemessene Magnetfeld eine Stärke hat, die im Absolutwert niedriger als die oder gleich der vordefinierten zweiten Schwelle $S_i$ ist.

2. Verfahren nach Anspruch 1, **dadurch gekennzeichnet, dass** es einen Schritt aufweist, der darin besteht, einen Alarm zu erzeugen (305; 406), wenn der Wert H einer linearen Kombination der erhaltenen Messungen höher ist als die vordefinierte dritte Schwelle $S_{tot}$.

3. Verfahren nach Anspruch 2, **dadurch gekennzeichnet, dass** es für jeden Hall-Sensor den folgenden Schritt aufweist:

   - Vergleichen (404) der erhaltenen Messung mit der vordefinierten zweiten Schwelle $S_i$;

und dass das Verfahren außerdem den folgenden Schritt aufweist:

   - Erzeugen (406) des Alarms, wenn mindestens eine der erhaltenen Messungen höher ist als die vordefinierte zweite Schwelle $S_i$.

4. Verfahren nach einem der Ansprüche 1 bis 3, **dadurch gekennzeichnet, dass** die vordefinierte dritte Schwelle $S_{tot}$ gemäß der folgenden Formel definiert wird:

$$S_{tot} = L \cdot \sqrt{\sum_{i=0}^{N-1} S_i^{\,2}}$$

wobei i ein für einen Hall-Sensor unter der Vielzahl von Hall-Sensoren repräsentativer Index ist, und wobei L ein Koeffizient gleich $1/\sqrt{N}$ ist, der es ermöglicht zu gewährleisten, dass, wenn alle vordefinierten zweiten Schwellen $S_i$ gleich sind, die vordefinierte dritte Schwelle $S_{tot}$ auch gleich jeder vordefinierten zweiten Schwelle $S_i$ ist, wobei N die Menge von Hall-Sensoren darstellt.

5. Verfahren nach Anspruch 4, **dadurch gekennzeichnet, dass** der Wert H einer linearen Kombination der erhaltenen Messungen folgendermaßen bestimmt wird:

$$H = \sum_{i=0}^{N-1} a_i, H_i$$

wobei $H_i$ die von dem durch den Index i dargestellten Hall-Sensor ausgeführte Messung darstellt, und $\alpha_i$ einen vordefinierten Gewichtungskoeffizienten der erhaltenen Messung des durch den Index i identifizierten Hall-Sensors darstellt, wobei jeder Gewichtskoeffizient $\alpha_i$ gemäß der folgenden Formel vordefiniert wird:

$$a_i = K, \frac{S_{tot}}{S_i}$$

wobei K ein Anpassungskoeffizient ist.

6. Ausrüstung zur Überwachung (130) einer Vorrichtung (100), die eine Vielzahl von Hall-Sensoren (110, 111, 112, 113) aufweist, wobei jeder Hall-Sensor geeignet ist, das Vorhandensein einer ein Magnetfeld einer Stärke höher als eine vordefinierte erste Schwelle $T_{src}$ erzeugenden Magnetquelle zu erfassen, wenn dieser Hall-Sensor eine Magnetfeldstärke im Absolutwert höher als eine vordefinierte zweite Schwelle $S_i$ misst, wobei die Ausrüstung aufweist:

- Einrichtungen zum Erhalt (301; 401) von Magnetfeldmessungen, die von den Hall-Sensoren ausgeführt werden; und diese Ausrüstung **dadurch gekennzeichnet ist, dass** sie aufweist:
- Einrichtungen zur Erfassung (304; 405), wenn ein Wert H einer linearen Kombination der Messungen im Absolutwert höher ist als eine vordefinierte dritte Schwelle $S_{tot}$, des Vorhandenseins einer Magnetquelle, die eine Magnetfeld einer Stärke höher als die vordefinierte erste Schwelle $T_{src}$ erzeugt, während das von jedem Hall-Sensor gemessene Magnetfeld eine Stärke hat, die im Absolutwert niedriger als die oder gleich der vordefinierten zweiten Schwelle $S_i$ ist.

7. Stromzähler, der geeignet ist, einen Stromverbrauch einer elektrischen Anlage zu messen, die von einem Stromnetz versorgt wird, **dadurch gekennzeichnet, dass** er die Überwachungsausrüstung nach Anspruch 6 aufweist, wobei der Stromzähler die die Hall-Sensoren aufweisende Vorrichtung ist.

8. Stromzähler nach Anspruch 7, **dadurch gekennzeichnet, dass** er aufweist:

- eine Powerline-Kommunikationsschnittstelle, die geeignet ist, über das Stromversorgungsnetz zu kommunizieren;
- Einrichtungen, um einen Alarm zu erzeugen (305; 406), wenn der Wert H einer linearen Kombination der erhaltenen Messungen höher ist als die vordefinierte dritte Schwelle $S_{tot}$; und
- Einrichtungen, um eine für den Alarm repräsentative Nachricht über die Powerline-Kommunikationsschnittstelle zu übertragen.

9. Computerprogramm, **dadurch gekennzeichnet, dass** es Anweisungen zur Durchführung des Verfahrens nach einem der Ansprüche 1 bis 5 durch eine Überwachungsausrüstung nach Anspruch 6 enthält, wenn das Programm von einem Prozessor der Überwachungsausrüstung ausgeführt wird.

10. Speichereinrichtungen, **dadurch gekennzeichnet, dass** sie ein Computerprogramm speichern, das Anweisungen zur Durchführung des Verfahrens nach einem der Ansprüche 1 bis 5 durch eine Überwachungsausrüstung nach Anspruch 6 enthält, wenn das Programm von einem Prozessor der Überwachungsausrüstung ausgeführt wird.

## Claims

1. Method for monitoring a device (100) comprising a plurality of Hall effect sensors (110, 111, 112, 113), each Hall effect sensor being adapted for detecting the presence of a magnetic source generating a magnetic field with an intensity greater than a first predefined threshold $T_{src}$ when this Hall effect sensor measures a magnetic field intensity higher in absolute value than a second respective predefined threshold $S_i$, said method comprising the following step:

- obtaining (301; 401) magnetic-field measurements made respectively by said Hall effect sensors;
and said method being **characterized in that** it comprises the following step:
- detecting (304; 405), when a value H of linear combination of said obtained measurements in absolute value is higher than a predefined third

threshold $S_{tot}$, the presence of a magnetic source generating a magnetic field with an intensity higher than said first predefined threshold $T_{src}$, while the magnetic field measured by each Hall effect sensor has an intensity in absolute value less than or equal to said respective predefined threshold $S_i$.

2. Method according to claim 1, **characterised in that** it comprises a step consisting of generating (305; 406) an alarm when the linear combination value H of said measurements obtained is higher than the third predefined threshold $S_{tot}$.

3. Method according to claim 2, **characterised in that** it comprises the following step, for each Hall effect sensor:

   - comparing (404) the obtained measurement with the respective second predefined threshold $S_i$,
   and **in that** said method further comprises the following step:
   - generating (406) the alarm when at least one among said obtained measurements is higher than said respective second predefined threshold $S_i$.

4. Method according to any one of claims 1 to 3, **characterised in that** said third predefined threshold $S_{tot}$ is defined according to the following formula:

$$S_{tot} = L . \sqrt{\sum_{i=0}^{N-1} S_i{}^2}$$

$$S_{tot} = L . \sqrt{\sum_{i=0}^{N-1} S_i{}^2}$$

where $i$ is an index representing one Hall effect sensor among the plurality of Hall effect sensors, and where L is a coefficient equal to $1/\sqrt{N}$ ensuring that, when all the second predefined thresholds $S_i$ are identical, the third predefined threshold $S_{tot}$ is also equal to each second predefined threshold $S_i$, N representing the quantity of Hall sensors.

5. Method according to claim 4, **characterised in that** the value H of linear combination of said obtained measurements is determined as follows:

$$H = \sum_{i=0}^{N-1} a_i . H_i$$

where $H_i$ represents the measurement made by the Hall effect sensor represented by the index $i$ and $a_i$ represents a predefined coefficient weighting the measurements obtained from the Hall effect sensor identified by the index $i$, each weighting coefficient $a_i$ being predefined according to the following formula

$$a_i = K . \frac{S_{tot}}{S_i}$$

where K is an adjustment coefficient.

6. Equipment (130) for monitoring a device (100) comprising a plurality of Hall effect sensors, each Hall effect sensor (110, 111, 112, 113) being adapted for detecting the presence of a magnetic source generating a magnetic field with an intensity greater than a first predefined threshold $T_{src}$ when this Hall effect sensor measures a magnetic field intensity higher in absolute value than a respective second predefined threshold $S_i$, said equipment comprising:

   - means for obtaining (301; 401) magnetic-field measurements made respectively by said Hall effect sensors;
   and said equipment being **characterized in that** it comprises:
   - means for detecting (304; 405), when a value H of linear combination of said obtained measurements in absolute value is higher than a third predefined threshold $S_{tot}$, the presence of a magnetic source generating a magnetic field with an intensity higher than said first predefined threshold $T_{src}$, while the magnetic field measured by each Hall effect sensor has an intensity in absolute value less than or equal to said respective second predefined threshold $S_i$.

7. Electricity meter adapted for measuring an electricity consumption of an electrical installation supplied by an electrical supply network, **characterised in that** it comprises the monitoring equipment according to claim 6, said electricity meter being the device comprising said Hall effect sensors.

8. Electricity meter according to claim 7, **characterised in that** it comprises:

   - an interface for powerline communication adapted for communicating via said electrical supply network;

- means for generating (305; 406) an alarm when the value H of linear combination of said obtained measurements is higher than the third predefined threshold $S_{tot}$; and
- means for transmitting a message representing said alarm via said powerline communication interface.

9. Computer program, **characterised in that** it comprises instructions for implementing, by monitoring equipment according to claim 6, the method according to any one of claims 1 to 5, when said program is executed by a processor of said monitoring equipment.

10. Storage means, **characterised in that** they store a computer program comprising instructions for implementing, by monitoring equipment according to claim 6, the method according to any one of claims 1 to 5, when said program is executed by a processor of said monitoring equipment.

| 110 | | 111 |
| 120 | |
| 112 | | 113 |

100

140

130

Fig. 1

| 201 CPU | 202 RAM | 203 ROM |

210

| 204 | 205 |

Fig. 2

Fig. 3

```
                    ┌─────────────────────┐
                    │       Début         │ ⌇300
                    └─────────────────────┘
                              │
                              ▼
          ┌───────────────────────────────────────┐
          │  Obtention de mesures de chaque        │
          │  capteur de courant à effet Hall       │ ⌇301
          └───────────────────────────────────────┘
                              │
                              ▼
       ┌──────────────────────────────────────────┐
       │  Détermination d'une valeur de combinaison│
       │  linéaire des mesures obtenues            │ ⌇302
       └──────────────────────────────────────────┘
                              │
                              ▼
        ┌─────────────────────────────────────────┐
        │  Comparaison de la valeur déterminée     │
        │  avec un seuil prédéfini S_tot           │ ⌇303
        └─────────────────────────────────────────┘
                              │
       305                    ▼                      306
┌──────────────┐  non ╱─────────────╲  oui  ┌──────────────┐
│  Génération   │◄─────┤     OK?      ├──────►│     Fin      │
│  d'une alarme │      ╲─────────────╱       └──────────────┘
└──────────────┘    304
```

Fig. 4

```
                    ┌─────────────────────┐
                    │       Début         │ ⌇400
                    └─────────────────────┘
                              │
                              ▼
          ┌───────────────────────────────────────┐
          │  Obtention de mesures de chaque        │
          │  capteur de courant à effet Hall       │ ⌇401
          └───────────────────────────────────────┘
                              │
                              ▼
       ┌──────────────────────────────────────────┐
       │  Détermination d'une valeur de combinaison│
       │  linéaire des mesures obtenues            │ ⌇402
       └──────────────────────────────────────────┘
                              │
                              ▼
        ┌─────────────────────────────────────────┐
        │  Comparaison de la valeur déterminée     │
        │  avec un seuil prédéfini S_tot           │ ⌇403
        └─────────────────────────────────────────┘
                              │
                              ▼
        ┌─────────────────────────────────────────┐
        │  Comparaison des mesures obtenues avec   │
        │  des seuils prédéfinis respectifs S_i    │ ⌇404
        └─────────────────────────────────────────┘
                              │
       406                    ▼                      407
┌──────────────┐  non ╱─────────────╲  oui  ┌──────────────┐
│  Génération   │◄─────┤     OK?      ├──────►│     Fin      │
│  d'une alarme │      ╲─────────────╱       └──────────────┘
└──────────────┘    405
```

# EP 2 977 773 B1

## RÉFÉRENCES CITÉES DANS LA DESCRIPTION

**Documents brevets cités dans la description**

- WO 2014106663 A1
- US 2011270553 A
- US 2004021568 A